# EUROPEAN PATENT APPLICATION

(11) **EP 4 664 754 A1**
(43) Date of publication of application: **17.12.2025**
(21) Application number: 23921003.2
(22) Date of filing: 06.02.2023
(51) Int. Cl.: H02S 50/10, H10K 30/40, H10K 30/50

(54) **PERFORMANCE EVALUATION DEVICE FOR SOLAR CELL ELEMENTS, AND PERFORMANCE EVALUATION METHOD FOR SOLAR CELL ELEMENTS**

(71) Applicant: Kabushiki Kaisha Toshiba, Tokyo 105-0023 (JP); Toshiba Energy Systems & Solutions Corporation, Saiwai-ku Kawasaki-shi Kanagawa 2120013 (JP)
(72) Inventor: ASATANI Tsuyoshi, Kawasaki-shi, Kanagawa 212-0013 (JP); FUJINAGA Kenji, Kawasaki-shi, Kanagawa 212-0013 (JP); TOBARI Tomohiro, Kawasaki-shi, Kanagawa 212-0013 (JP)
(74) Representative: Henkel & Partner mbB
(86) International application number: PCT/JP2023/003780
(87) International publication number: WO 2024/166166

(57) **Abstract**

A performance evaluation device (10) for solar cell elements according to an embodiment of the present invention has an evaluation unit (11) and a preparation unit (20). The evaluation unit (11) has a first light source (12) that irradiates, with light, solar cell elements (1) each including a perovskite semiconductor, and evaluates the power generation performance of the solar cell elements (1). The preparation unit (20) has a second light source (22) that irradiates, with light, the solar cell elements (1) before being transported to the evaluation unit (11), and prepares for evaluation of the power generation performance of the solar cell elements (1).

## Description

### TECHNICAL FIELD

An embodiment of the present invention relates to a performance evaluation device for solar cell elements and a performance evaluation method for solar cell elements.

### BACKGROUND ART

There is a demand to reduce an evaluation time in a performance evaluation device for solar cell elements and a performance evaluation method for solar cell elements.

### Citation List

### Patent Document

Patent Document 1: Japanese Patent No. 6916538

### SUMMARY OF INVENTION

### Technical Problem

A problem to be solved by the present invention is to provide a performance evaluation device for solar cell elements and a performance evaluation method for solar cell elements capable of reducing a performance evaluation time.

### Solution to Problem

A performance evaluation device for solar cell elements of an embodiment includes an evaluation unit and a preparation unit. The evaluation unit includes a first light source which irradiates each of solar cell elements containing a perovskite semiconductor with light, and evaluates a power generation performance of the solar cell element. The preparation unit includes a second light source which irradiates the solar cell elements with light before the solar cell elements are transported to the evaluation unit, and prepares for evaluation of power generation performances of the solar cell elements.

### BRIEF DESCRIPTION OF DRAWINGS

[FIG. 1] A schematic configuration view of a performance evaluation device for solar cell elements of a first embodiment.
[FIG. 2] A schematic configuration view of a performance evaluation device for solar cell elements in a first modified example of the first embodiment.
[FIG. 3] A side view of a clip member.
[FIG. 4] A schematic configuration view of a performance evaluation device for solar cell elements of a second embodiment.
[FIG. 5] A schematic configuration view of a performance evaluation device for solar cell elements of a third embodiment.
[FIG. 6] An exploded view in a vicinity of a probe.
[FIG. 7] A plan view of a tension mechanism.
[FIG. 8] An enlarged view of portion VIII at position A of FIG. 7.
[FIG. 9] A cross-sectional view along line IX-IX of FIG. 8.
[FIG. 10] An enlarged view of portion X at position B of FIG. 7.
[FIG. 11] A cross-sectional view along line XI-XI of FIG. 10.
[FIG. 12] An enlarged view of portion XII at position C of FIG. 7.
[FIG. 13] A cross-sectional view along line XIII-XIII of FIG. 12.

### DESCRIPTION OF EMBODIMENTS

Hereinafter, a performance evaluation device for solar cell elements and a performance evaluation method for solar cell elements will be described with reference to the drawings.

### (First embodiment)

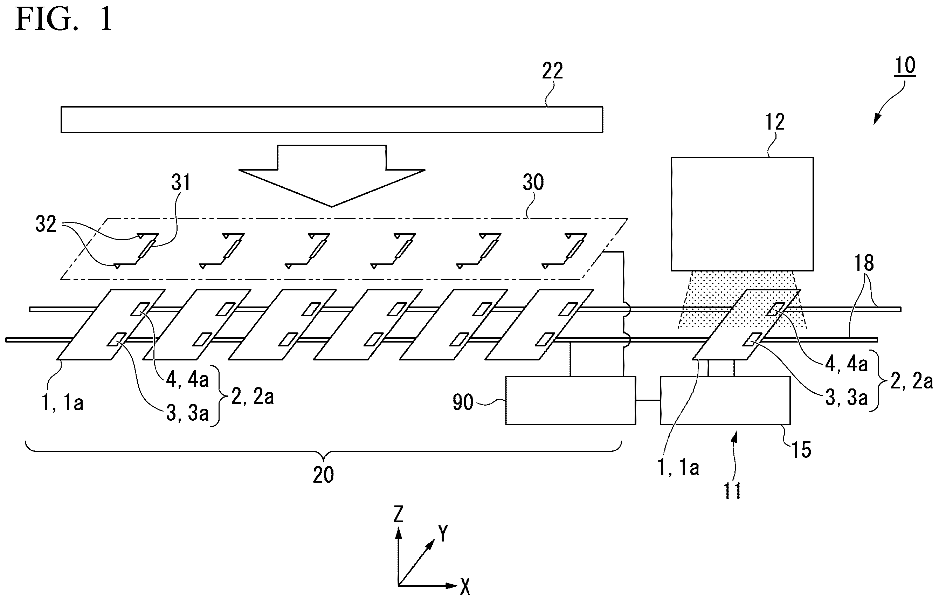

FIG. 1 is a schematic configuration view of a performance evaluation device 10 for solar cell elements of a first embodiment. A solar cell element 1 has, as a perovskite semiconductor, a perovskite structure at least in part. A perovskite structure is one of crystal structures and has the same crystal structure as perovskite. Typically, a perovskite structure is composed of ions A, B, and X, and is represented by the following general expression (1).

ABX₃ ··· (1)

A primary ammonium ion can be used as the A ion. Specific examples include CH₃NH₃⁺ (hereinafter sometimes referred to as MA), C₂H₅NH₃⁺, C₃H₇NH₃⁺, C₄H₉NH₃⁺, and HC(NH₂)₂⁺ (hereinafter sometimes referred to as FA), with CH₃NH₃⁺ being preferred, but are not limited thereto. Cs⁺, Rb⁺, and 1,1,1-trifluoroethylammonium iodide (FEAI) are also preferable as the A ion, but the A ion is not limited thereto. As the B ion, divalent metal ions such as Pb²⁺ or Sn²⁺ can be used, but the B ion is not limited thereto. As the X ion, halide ions such as Cl⁻, Br⁻, or I⁻ can be used. A material constituting the ions A, B, or X may be a single material or a mixture. The constituent ions can function even if they do not necessarily match a stoichiometric ratio of ABX₃.

The solar cell element 1 of the first embodiment is a first solar cell element 1a. The first solar cell element 1a is a tandem-type solar cell element in which a top cell and a bottom cell are laminated. The top cell contains a perovskite semiconductor. The bottom cell contains silicon. The first solar cell element 1a containing silicon is a hard panel-type (cell-type) solar cell element.

The solar cell element 1 has a terminal 2. The terminal 2 is a pair of terminals constituted by a positive terminal 3 and a negative terminal 4 and electrically connects the solar cell element 1 to the outside. The first solar cell element 1a has a pair of terminals 2a (a positive terminal 3a and a negative terminal 4a) disposed on a surface on the top cell side.

The performance evaluation device 10 for solar cell elements has an evaluation unit **11** that evaluates power generation performance of the solar cell element 1.

The evaluation unit 11 measures, for example, IV (current vs. voltage) curve characteristics of the solar cell element 1. The evaluation unit **11** includes a first light source 12 and a measurement unit 15. The first light source 12 irradiates the solar cell element 1 with light. For example, the first light source 12 is a xenon (Xe) lamp or a halogen lamp. The solar cell element 1 generates electrons and holes (carriers) through light reception, thereby generating electricity. The measurement unit 15 connects a probe to the terminal 2 of the solar cell element 1 to measure the power generation performance of the solar cell element 1.

The performance evaluation device 10 evaluates power generation performances of the solar cell elements 1 using an in-line method. The performance evaluation device 10 includes a transport device 18 that sequentially transports the solar cell elements 1 one by one to the evaluation unit 11.

The transport device 18 extends from a preparation unit 20 to be described later toward the evaluation unit 11. The transport device 18 supports the solar cell elements 1 aligned in a single row. The transport device 18 is, for example, a pair of rails, belts, or the like. The transport device 18 may have a configuration of a single continuous segment extending in an X-axis direction from the preparation unit 20 to the evaluation unit 11, or may have a configuration divided into two or more segments. When a configuration divided into two or more segments is used, a transport speed in the preparation unit 20 and the evaluation unit 11 can be varied, and therefore, there is no need to match a distance from the preparation unit 20 to the evaluation unit 11 with a pitch of the solar cell elements 1 in the preparation unit 20. The transport device 18 may support the solar cell element 1 by suction using a negative pressure, or may support it using a claw (not illustrated) attached to the transport device 18. The evaluation unit 11 evaluates the power generation performance while transportation of the solar cell element 1 is stopped. The transport device 18 intermittently transports the solar cell element 1 each time the evaluation of the solar cell element 1 is completed in the evaluation unit 11. When the in-line method is employed, since only one or a small number of evaluation units 11 are required, costs of the performance evaluation device 10 are reduced.

In the present application, a Z direction, an X direction, and a Y direction of a Cartesian coordinate system are defined as follows. The Z direction is a direction in which the solar cell element 1 is supported with respect to the transport device 18. For example, the Z direction is a vertical direction, and a +Z direction is an upward direction. The X direction is a direction in which the solar cell element 1 is transported by the transport device 18. A +X direction (first direction) is a downstream side in the transport direction. A Y direction is a width direction of the transport device 18. For example, the X direction and the Y direction are horizontal directions. The solar cell element 1 is disposed in the +Z direction of the transport device 18 in a state parallel to an XY plane. The first light source 12 is disposed in the +Z direction of the transport device 18 and irradiates light in a -Z direction. The first light source 12 may be disposed in the -Z direction of the transport device 18 and irradiate light in the +Z direction.

Generally, the solar cell element 1 containing a perovskite semiconductor requires a predetermined amount of time (approximately several minutes) from the start of light reception until the power generation performance stabilizes. The performance evaluation device 10 includes the preparation unit 20 that prepares for evaluation of power generation performances of the solar cell elements 1.

The preparation unit 20 irradiates the solar cell elements 1 with light before they are transported to the evaluation unit 11. The preparation unit 20 is disposed in the -X direction of the evaluation unit 11. The preparation unit 20 irradiates a plurality of solar cell elements 1 supported by the transport device 18 with light. The solar cell element 1 passes through the preparation unit 20 for a predetermined amount of time. The power generation performances of the solar cell elements 1 are stabilized by passing through the preparation unit 20. The evaluation unit 11 can immediately evaluate the power generation performance of the solar cell element 1 transported from the preparation unit 20. An evaluation time of the performance evaluation device 10 is reduced. An evaluation accuracy of the performance evaluation device 10 is improved.

The preparation unit 20 includes a second light source 22 that irradiates the plurality of solar cell elements 1 with light. The second light source 22 is disposed in the +Z direction of the transport device 18 and irradiates light in the -Z direction. The number of light sources may be one or more. The second light source 22 is limited to a light source whose emission wavelength falls within a wavelength region absorbed by the solar cell element 1. For example, xenon lamps, high-pressure mercury lamps, halogen lamps, LEDs, or the like can be used. It is desirable that an irradiation range of the second light source 22 cover the entire power generation area of the solar cell element 1, but the present invention is not limited thereto. For example, the second light source 22 is a light-emitting diode (LED). When an LED is employed, costs of the second light source 22 can be reduced, and a temperature rise of the second light source 22 and the solar cell element 1 can be suppressed.

When the solar cell element 1 is irradiated with light in the preparation unit 20, charge separation occurs due to a photoelectric effect, thereby generating electrons and holes. When electrons or holes accumulate in the solar cell element 1, the solar cell element 1 deteriorates. In order to consume electrons or holes generated in the solar cell element 1 in the preparation unit 20, a resistor 31 is connected to the solar cell element 1.

The preparation unit 20 of the first embodiment includes the resistor 31, a probe 32, and a support member 30.

The resistor 31 can form a closed circuit by being connected to the first solar cell element 1a. It is desirable that the resistor 31 be a fixed resistor having a resistance value corresponding to a maximum output voltage (Vmpp) and a maximum output current (Impp) of the first solar cell element 1a, but is not limited thereto. The resistor 31 may be a variable resistor. A resistance value of the variable resistor is tuned to correspond to a maximum output of the first solar cell element 1a to which it is connected. Such a resistor 31 efficiently consumes electrons or holes.

The preparation unit 20 includes a plurality of resistors 31. The plurality of resistors 31 are disposed to be aligned in the X direction at the same pitch as the first solar cell elements 1a. The number of resistors 31 matches the number of first solar cell elements 1a included in the preparation unit 20. Since only a small number of resistors 31 are required, the costs of the performance evaluation device 10 are reduced.

The probe 32 is capable of connecting the resistor 31 to the terminal 2a of the first solar cell element 1a.

The support member 30 is disposed in the +Z direction of the transport device 18. For example, the support member 30 is a frame parallel to the XY plane. The resistor 31 and the probe 32 are attached in the -Z direction of the support member 30. The support member 30, together with the probe 32, is movable in the Z direction that intersects a surface of the terminal 2a of the first solar cell element 1a. The probe 32 is capable of coming into contact with and being separated from the terminals 2a as the support member 30 moves in the Z direction. When the support member 30 moves in the -Z direction, the probe 32 comes into contact with the terminal 2a. Thereby, the resistor 31 and the first solar cell element 1a are connected. When the support member 30 moves in the +Z direction, the probe 32 separates from the terminals 2a. Thereby, the connection between the resistor 31 and the first solar cell element 1a is released.

A control unit 90 is a microcomputer including a processor such as a CPU or a GPU. The control unit 90 has a function of controlling an operation of each unit of the performance evaluation device 10. The functions of the control unit 90 are realized by, for example, a processor such as a CPU executing a program. Also, some or all of the functions of the control unit 90 may be realized by hardware such as a large scale integration (LSI), an application specific integrated circuit (ASIC), and a field-programmable gate array (FPGA), or may be realized through cooperation of software and hardware.

An operation of the performance evaluation device 10 of the first embodiment will be described.

The evaluation unit 11 evaluates power generation performance of the first solar cell element 1a. The first light source 12 irradiates the first solar cell element 1a in the evaluation unit 11 with light. The measurement unit 15 measures the power generation performance of the first solar cell element 1a.

The preparation unit 20 irradiates, with light, the first solar cell element 1a before the power generation performance is evaluated (preparation step). The preparation unit 20 stabilizes the power generation performance of the first solar cell elements 1a before they are transported to the evaluation unit 11. The second light source 22 irradiates the plurality of first solar cell elements 1a in the preparation unit 20 with light. The resistor 31 is connected to the first solar cell element 1a. The resistor 31 consumes electrons or holes generated in the first solar cell element 1a.

After measurement of the power generation performance and before transport of the first solar cell element 1a, a probe of the measurement unit 15 separates from the first solar cell element 1a in the evaluation unit 11.

Before the first solar cell element 1a is transported, the support member 30 of the preparation unit 20 moves in the +Z direction. The probe 32 is separated from the terminal 2 of the first solar cell element 1a in the preparation unit 20. Before the first solar cell element 1a is transported, the connection between the first solar cell element 1a and the resistor 31 is released.

The transport device 18 transports the first solar cell element 1a in the +X direction.

The first solar cell element 1a after measurement of the power generation performance exits the evaluation unit 11. The first solar cell element 1a before measurement of the power generation performance enters the evaluation unit 11.

The plurality of first solar cell elements 1a in the preparation unit 20 each shift in the +X direction to a position of the first solar cell element 1a adjacent in the +X direction. The first solar cell element 1a that has been at an end part in the +X direction inside the preparation unit 20 exits the preparation unit 20. The first solar cell element 1a that has been on an outer side of the preparation unit 20 in the -X direction enters the preparation unit 20.

The probe of the measurement unit 15 of the evaluation unit **11** is connected to the first solar cell element 1a. The evaluation unit 11 evaluates the power generation performance of the first solar cell element 1a (evaluation step).

The support member 30 moves in the -Z direction. The probe 32 comes into contact with the terminal 2 of the first solar cell element 1a in the preparation unit 20. The first solar cell element 1a, that is adjacent to the first solar cell element 1a in the -X direction from which the connection with the resistor 31 has been released before the first solar cell element 1a is transported, and the resistor 31 are connected after the first solar cell element 1a is transported. The resistors 31 are sequentially connected to the plurality of first solar cell elements 1a. The preparation unit 20 irradiates the first solar cell elements 1a with light before they are transported to the evaluation unit 11.

As described above in detail, the performance evaluation device 10 for solar cell elements of the first embodiment includes the evaluation unit 11 and the preparation unit 20. The evaluation unit 11 includes the first light source 12 that irradiates the solar cell element 1 containing a perovskite semiconductor with light, and evaluates the power generation performance of the solar cell element 1. The preparation unit 20 includes the second light source 22 that irradiates the solar cell elements 1 with light before they are transported to the evaluation unit 11, and prepares for evaluation of power generation performances of the solar cell elements 1.

The performance evaluation method for solar cell elements of the first embodiment includes the preparation step and the evaluation step. In the preparation step, the solar cell element 1 containing a perovskite semiconductor is irradiated with light before the power generation performance of the solar cell element 1 is evaluated. In the evaluation step, the power generation performance of the solar cell element 1 is evaluated.

The preparation unit 20 irradiates the solar cell elements 1 with light before they are transported to the evaluation unit 11. The power generation performance of the solar cell element 1 is stabilized. The evaluation unit **11** can immediately evaluate the power generation performance of the solar cell element 1 transported from the preparation unit 20. An evaluation time of the performance evaluation device 10 is reduced.

The preparation unit 20 includes the resistor 31 that can form a closed circuit by being connected to the first solar cell element 1a.

When the first solar cell element 1a is irradiated with light in the preparation unit 20, electrons or holes are generated. The resistor 31 consumes the electrons or holes generated in the preparation unit 20 to suppress accumulation of the electrons or holes. Deterioration of the first solar cell element 1a is suppressed.

The performance evaluation device 10 includes the transport device 18. The transport device 18 extends in the +X direction from the preparation unit 20 toward the evaluation unit 11, supports the solar cell elements 1 aligned in a row, and sequentially transports the solar cell elements 1 to the evaluation unit 11.

The performance evaluation device 10 evaluates the power generation performances of the solar cell elements 1 using an in-line method. Since only one or a small number of evaluation units 11 are required, the costs of the performance evaluation device 10 are reduced.

Before the first solar cell element 1a is transported, the connection between the first solar cell element 1a and the resistor 31 is released. The first solar cell element 1a, that is positioned in the -X direction of the first solar cell element 1a from which the connection with the resistor 31 has been released, and the resistor 31 are connected after the first solar cell element 1a is transported.

The resistors 31 are sequentially connected to the plurality of first solar cell elements 1a. The number of resistors 31 matches the number of first solar cell elements 1a included in the preparation unit 20. Since only a small number of resistors 31 are required, the costs of the performance evaluation device 10 are reduced.

The preparation unit 20 includes the resistor 31 and the probe 32. The probe 32 is capable of connecting the resistor 31 to the first solar cell element 1a. The probe 32 is movable in the Z direction intersecting a surface of the terminal of the first solar cell element 1a.

The support member 30 supporting the probe 32 cooperates with the transport device 18 to sequentially connect the resistors 31 to the plurality of first solar cell elements 1a. Since only a small number of resistors 31 are required, the costs of the performance evaluation device 10 are reduced.

The second light source 22 is an LED.

When an LED is employed, costs of the second light source 22 can be reduced, and a temperature rise of the second light source 22 and the solar cell element 1 can be suppressed. The LED is preferably a white LED, but may be a blue LED, a green LED, a red LED, or the like.

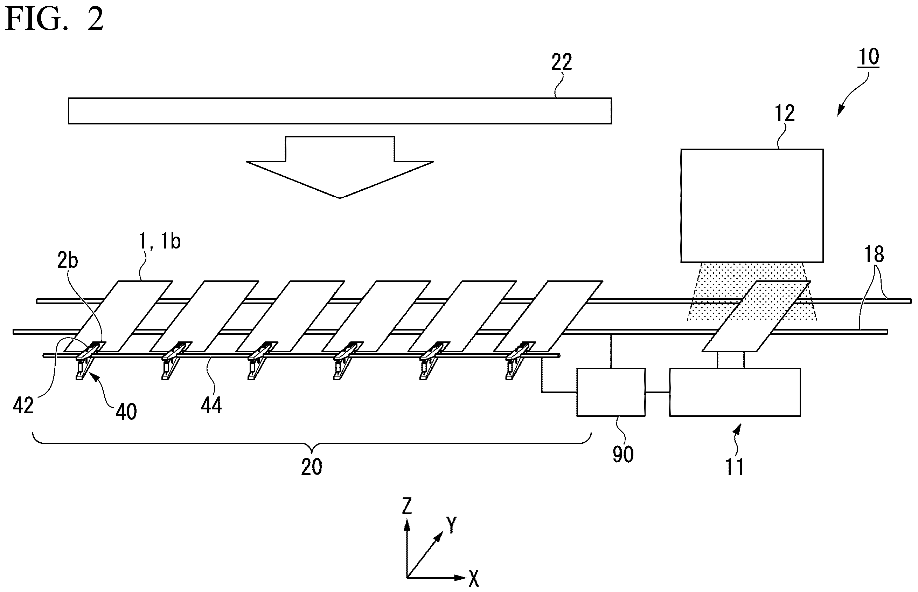

FIG. 2 is a schematic configuration view of a performance evaluation device 10 for solar cell elements in a first modified example of the first embodiment.

The solar cell element 1 of the first modified example is a second solar cell element 1b. Similarly to the first solar cell element 1a, the second solar cell element 1b is a tandem-type solar cell element in which a top cell and a bottom cell are laminated. The second solar cell element 1b has terminals 2b disposed on a surface on the top cell side and on a surface on the bottom cell side, respectively.

The preparation unit 20 of the performance evaluation device 10 of the first modified example includes a plurality of clip members 40. The number of clip members 40 matches the number of second solar cell elements 1b included in preparation unit 20. The clip members 40 are each disposed at an end part of the second solar cell element 1b in the -Y direction. The plurality of clip members 40 are supported by a support rod 44 extending in the X direction.

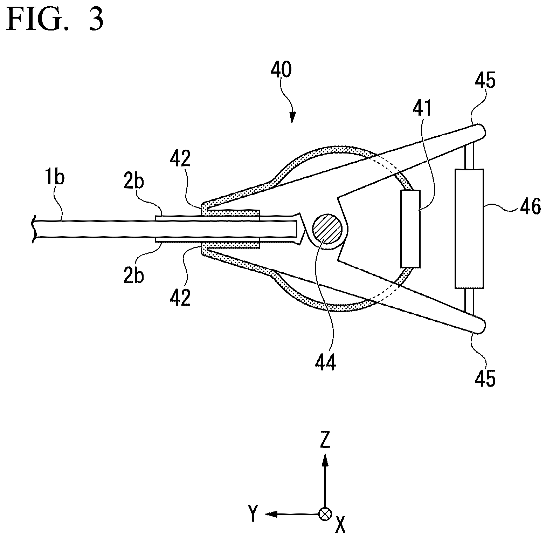

FIG. 3 is a side view of the clip member 40. The clip member 40 includes a pair of levers 45, a pair of probes 42, a resistor 41, and an actuator 46.

The pair of levers 45 are formed of an electrically insulating material such as a resin. The pair of levers 45 are aligned in the Z direction with the support rod 44 interposed therebetween. The levers 45 extend in the Y direction in a plan view. The levers 45 are rotatable with the support rod 44 as a center.

The pair of probes 42 extend from the resistor 41. The pair of probes 42 are attached to distal ends of the pair of levers 45 in the +Y direction. The pair of probes 42 can connect the resistor 41 to the second solar cell element 1b.

The resistor 41 can form a closed circuit by being connected to the second solar cell element 1b.

The actuator 46 is, for example, a pneumatic piston. The actuator 46 is disposed between the pair of levers 45 in the -Y direction of the support rod 44. The second solar cell element 1b is disposed between the pair of levers 45 in the +Y direction of the support rod 44. The actuator 46 extends and contracts to move the distal ends in the +Y direction of the pair of levers 45 in the Z direction. The actuator 46 moves the pair of probes 42 in the Z direction via the pair of levers 45. The pair of probes 42 are movable in the Z direction that intersects a surface of the terminal 2b of the second solar cell element 1b.

When the actuator 46 extends, the distal ends of the pair of levers 45 in the +Y direction move closer to each other. The pair of probes 42 come into contact with the terminals 2b disposed on both sides of the second solar cell element 1b. When the actuator 46 contracts, the end parts of the pair of levers 45 in the +Y direction separate from each other. The pair of probes 42 separate from the terminals 2b disposed on both sides of the second solar cell element 1b. The actuator 46 is capable of adjusting a pressing force of the pair of probes 42 against the terminal 2b of the second solar cell element 1b. Since the pair of probes 42 are operated by one actuator 46, the costs of the performance evaluation device 10 are reduced.

Also in the performance evaluation device 10 of the first modified example, similarly to the first embodiment, the second solar cell element 1b and the resistor 41 are connected and disconnected. Before the second solar cell element 1b is transported, connection between the second solar cell element 1b and the resistor 41 is released. The second solar cell element 1b, that is adjacent to the second solar cell element 1b in the -X direction from which the connection with the resistor 41 has been released, and the resistor 41 are connected after the second solar cell element 1b is transported. The resistors 41 are sequentially connected to the plurality of second solar cell elements 1b.

### (Second embodiment)

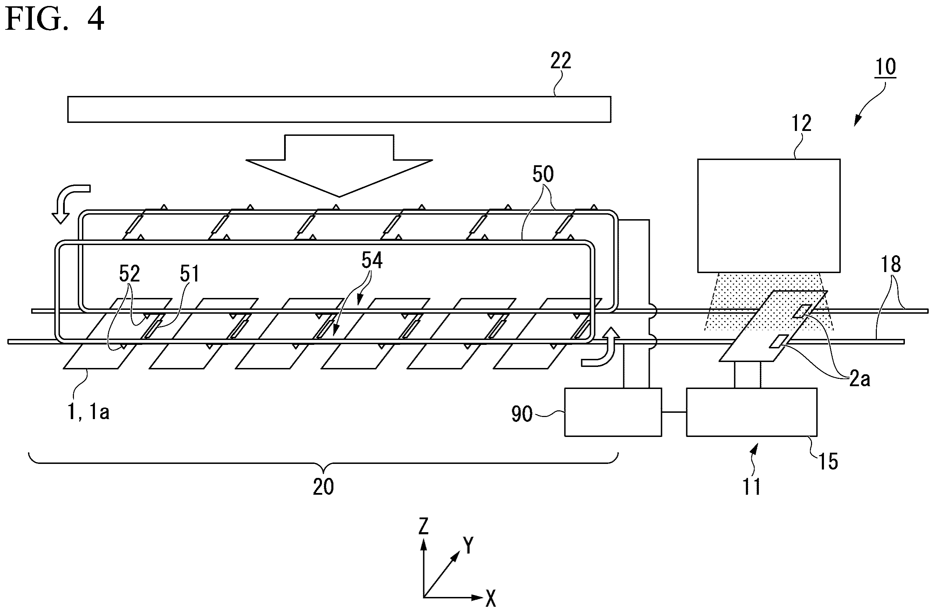

FIG. 4 is a schematic configuration view of a performance evaluation device 10 for solar cell elements of a second embodiment. The performance evaluation device 10 for solar cell elements in the second embodiment differs from the first embodiment in that a resistor 51 moves in synchronization with a first solar cell element 1a while being connected to the first solar cell element 1a. Description of portions of the second embodiment that are the same as those in the first embodiment may be omitted.

A solar cell element 1 of the second embodiment is the same as the first solar cell element 1a of the first embodiment.

A preparation unit 20 of the performance evaluation device 10 of the second embodiment includes a rotating member 50, the resistor 51, and a probe 52.

The rotating member 50 is disposed in a +Z direction of a transport device 18. For example, the rotating member 50 is an endless caterpillar-shaped object. A surface of the rotating member 50 is covered with an insulating material. The rotating member 50 is rotatable parallel to an XZ plane.

A synchronous movement portion 54 is formed at an end part of the rotating member 50 in a -Z direction. The synchronous movement portion 54 is movable in a +X direction in synchronization with the transport device 18. The synchronous movement portion 54 moves and stops at the same timing as the transport device 18. The synchronous movement portion 54 moves at the same speed as the transport device 18. The synchronous movement portion 54 is in a range including the preparation unit 20 in an X direction.

The resistor 51 can form a closed circuit by being connected to the first solar cell element 1a. The rotating member 50 holds a plurality of resistors 51 between the endless caterpillar-shaped objects. The plurality of resistors 51 are disposed to be aligned in a circumferential direction of the rotating member 50 at the same pitch as the first solar cell elements 1a.

The probe 52 is capable of connecting the resistor 51 to the terminal 2a of the first solar cell element 1a.

The rotating member 50 holds the resistor 51 and the probe 52. The rotating member 50, together with the probe 52, is movable in a Z direction that intersects a surface of the terminal 2a of the first solar cell element 1a. The probe 52 is capable of coming into contact with and being separated from the terminal 2a of the first solar cell element 1a as the rotating member 50 moves in the Z direction.

An operation of the performance evaluation device 10 of the second embodiment will be described.

An evaluation unit 11 evaluates power generation performance of the first solar cell element 1a.

A second light source 22 of the preparation unit 20 irradiates the first solar cell elements 1a with light before they are transported to the evaluation unit 11. The resistor 51 held on the synchronous movement portion 54 of the rotating member 50 is connected to the first solar cell element 1a.

After evaluation of the power generation performance in evaluation unit 11, the transport device 18 transports first solar cell element 1a in the +X direction. The synchronous movement portion 54 of the rotating member 50 moves in the +X direction in synchronization with the transport device 18. The resistor 51 moves in the +X direction in synchronization with the first solar cell element 1a while being connected to the first solar cell element 1a.

The first solar cell element 1a that has been at an end part in the +X direction inside the preparation unit 20 exits the preparation unit 20. The resistor 51 that has been connected to the exited first solar cell element 1a moves in the +Z direction as the rotating member 50 rotates and exits the synchronous movement portion 54. The connection between the first solar cell element 1a exited from the preparation unit 20 and the resistor 51 exited from the synchronous movement portion 54 is released. The first solar cell element 1a that has been on an outer side of the preparation unit 20 in a -X direction enters the preparation unit 20. As the rotating member 50 rotates, the resistor 51 moved in the -Z direction enters the synchronous movement portion 54. The first solar cell element 1a entered the preparation unit 20 and the resistor 51 entered the synchronous movement portion 54 are connected. The resistors 51 are connected to all of the first solar cell elements 1a in the preparation unit 20.

The rotating member 50 moves in the -Z direction during rotation or after the rotation has stopped. The probe 52 held by the rotating member 50 moves in the -Z direction. Even if a gap occurs between the terminal 2a of the first solar cell element 1a and the probe 52, the gap is eliminated by the probe 52 moving in the -Z direction. Reliability of the connection between the first solar cell element 1a and the resistor 51 is improved.

As described above in detail, in the performance evaluation device 10 of the second embodiment, the resistor 51 moves in synchronization with the first solar cell element 1a while being connected to the first solar cell element 1a.

The resistor 51 having a resistance value corresponding to a maximum output of the first solar cell element 1a is continuously connected to the first solar cell element 1a. Electrons or holes are efficiently consumed, and deterioration of the first solar cell element 1a is suppressed.

The performance evaluation device 10 further includes the endless rotating member 50. The rotating member 50 includes the synchronous movement portion 54 that is movable in synchronization with the transport device 18.

As the endless rotating member 50 rotates, the synchronous movement portion 54 is continuously formed. The resistors 51 are connected to all of the first solar cell elements 1a passing through the preparation unit 20.

The rotating member 50 holds the resistor 51 and the probe 52 capable of connecting the resistor 51 to the first solar cell element 1a. The rotating member 50 is movable in the Z direction that intersects a surface of the terminal 2a of the first solar cell element 1a.

Even if a gap occurs between the terminal 2a of the first solar cell element 1a and the probe 52, the gap is eliminated by the probe 52 moving in the -Z direction. The reliability of the connection between the first solar cell element 1a and the resistor 51 is improved.

### (Third embodiment)

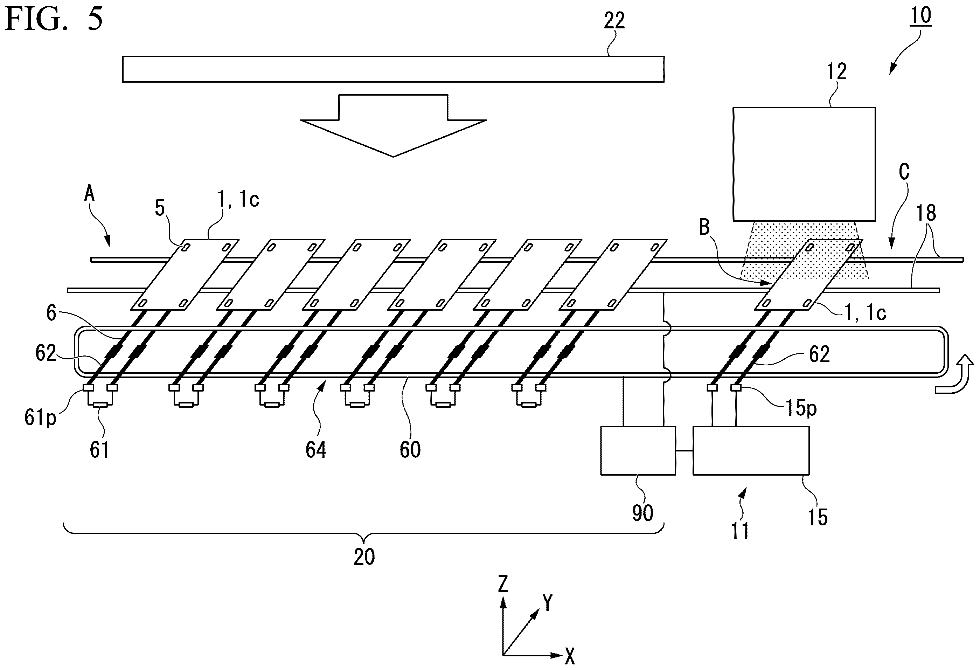

FIG. 5 is a schematic configuration view of a performance evaluation device 10 for solar cell elements of a third embodiment. The performance evaluation device 10 for solar cell elements in the third embodiment differs from the second embodiment in that a rotating member 60 holds a probe 62 that can connect a cable 6 extending from a third solar cell element 1c and a resistor 61. Description of portions of the third embodiment that are the same as those in the first or second embodiment may be omitted.

A solar cell element 1 of the third embodiment is the third solar cell element 1c. The third solar cell element 1c is formed of a plurality of cells, each containing a perovskite semiconductor, which are disposed to be aligned on a film substrate and connected to each other. The third solar cell element 1c is a module-type solar cell element having flexibility.

The third solar cell element 1c includes a pair of cables 6. The cable 6 extends from an end part of the third solar cell element 1c in a -Y direction to the outside of the third solar cell element 1c. The cable 6 can electrically connect the third solar cell element 1c to the outside.

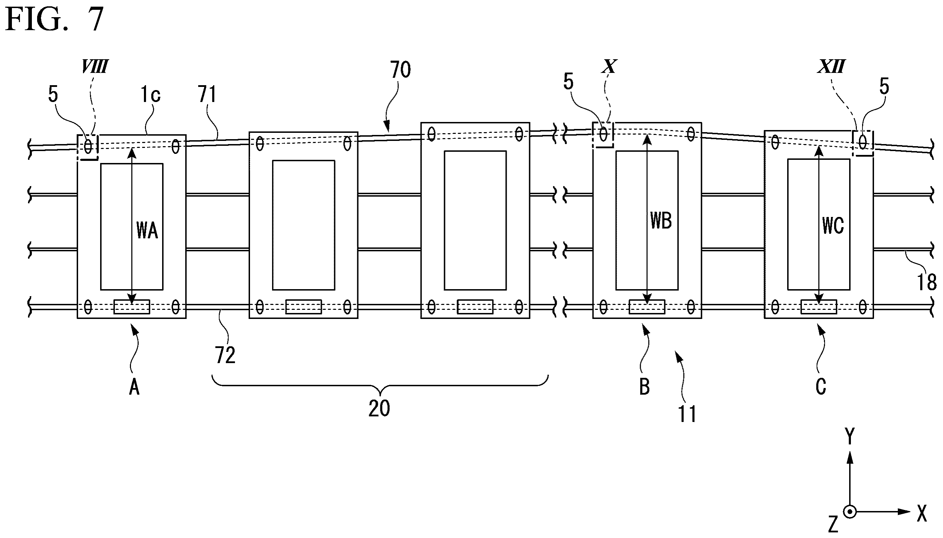

A preparation unit 20 of the performance evaluation device 10 of the third embodiment includes the rotating member 60, the resistor 61, the probe 62, and a tension mechanism 70 (see FIG. 7).

The rotating member 60 is disposed in the -Y direction of a transport device 18. For example, the rotating member 60 is an endless wire. The rotating member 60 is rotatable parallel to an XZ plane. A synchronous movement portion 64 is formed at an end part of the rotating member 60 in a -Z direction. The synchronous movement portion 64 is movable in a +X direction in synchronization with the transport device 18. The synchronous movement portion 64 extends in an X direction from position A in a -X direction of the preparation unit 20 to position C in the +X direction of an evaluation unit 11. The rotating member 60 is also movable in a Z direction.

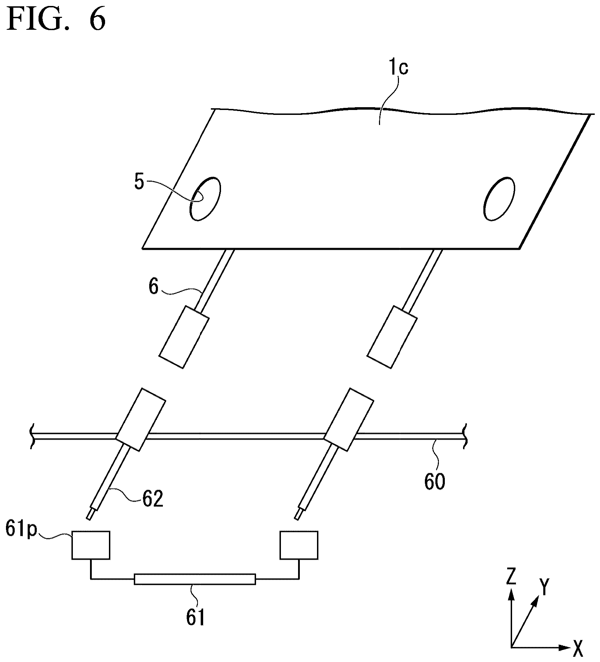

FIG. 6 is an exploded view in a vicinity of the probe 62.

The resistor 61 can form a closed circuit by being connected to the third solar cell element 1c. The resistor 61 is disposed away from the rotating member 60 in the -Y direction. A plurality of resistors 61 are disposed to be aligned in the X direction at the same pitch as the third solar cell elements 1c (see FIG. 5). The resistors 61 each have a pair of connection pads 61p. The connection pad 61p is capable of electrically connecting the resistor 61 to the outside. A surface of the connection pad 61p is parallel to an XY plane. The rotating member 60 is movable in the Z direction that intersects the surface of the connection pad 61p.

The probe 62 is held by the rotating member 60. A plurality of probes 62 are disposed to be aligned in a circumferential direction of the rotating member 60 at the same pitch as the third solar cell elements 1c (see FIG. 5). An end part of the probe 62 in the +Y direction can be connected to the cable 6 of the third solar cell element 1c. An end part of the probe 62 in the -Y direction is capable of coming into contact with the connection pad 61p of the resistor 61. Thereby, the probe 62 can connect the resistor 61 to the third solar cell element 1c. The probe 62 is capable of coming into contact with and being separated from the connection pad 61p of the resistor 61 as the rotating member 60 moves in the Z direction.

As illustrated in FIG. 5, a measurement unit 15 of the evaluation unit 11 of the performance evaluation device 10 includes a pair of connection pads 15p. The connection pad 15p of the measurement unit 15 is at the same position as the connection pad 61p of the resistor 61 in the Y and Z directions. The probe 62 is capable of coming into contact with the connection pad 15p of the measurement unit 15. Thereby, the probe 62 can connect the measurement unit 15 to the third solar cell element 1c.

As described above, the third solar cell element 1c has flexibility. When the third solar cell element 1c is in a bent state, the transport device 18 cannot adsorb the third solar cell element 1c. When the third solar cell element 1c is in a bent state, a first light source 12 and a second light source 22 cannot sufficiently irradiate the third solar cell element 1c with light. The tension mechanism 70 (see FIG. 7) pulls the third solar cell element 1c in the Y direction intersecting the -Z direction which is a light irradiation direction of the first light source 12 and the second light source 22. The tension mechanism 70 pulls the third solar cell element 1c, which is supported by the transport device 18, in the Y direction to eliminate the bending of the third solar cell element 1c.

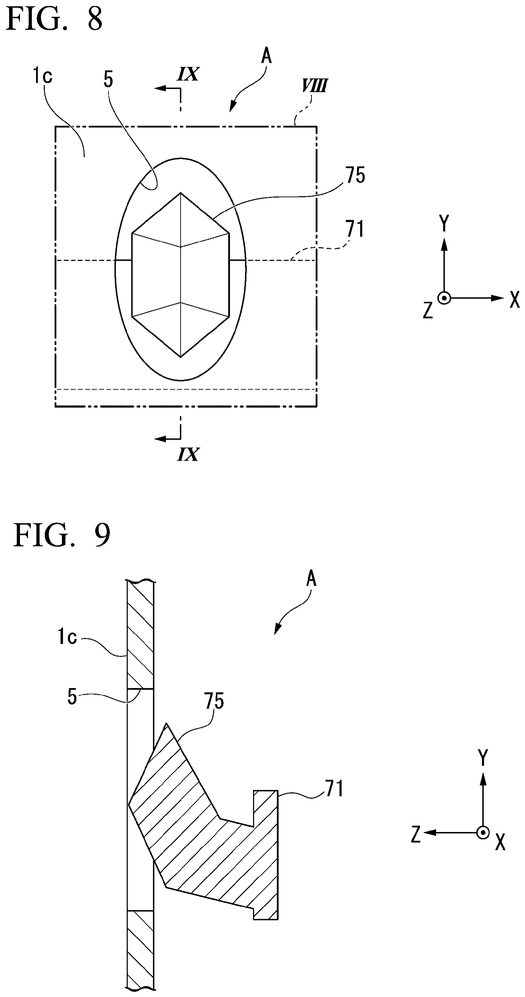

FIG. 7 is a plan view of the tension mechanism 70. The tension mechanism 70 includes rotating belts 71 and 72 and a hook 75 (see FIG. 9). The third solar cell element 1c has through holes 5 at four corners. The through holes 5 each penetrate the third solar cell element 1c in the Z direction. The tension mechanism 70 pulls the third solar cell element 1c in the Y direction by engaging the hook 75 with the through hole 5.

The rotating belts 71 and 72 are rotatable approximately parallel to an XZ plane. The rotating belts 71 and 72 include a first rotating belt 71 and a second rotating belt 72. The first rotating belt 71 is disposed in the +Y direction of the transport device 18. The second rotating belt 72 is disposed in the -Y direction of the transport device 18. The rotating belts 71 and 72 are disposed in the -Z direction of the third solar cell element 1c supported by the transport device 18. A synchronous movement portion is formed at end parts of the rotating belts 71 and 72 in the +Z direction. The synchronous movement portion is capable of moving in the +X direction in synchronization with the transport device 18. The synchronous movement portion is in a range including the preparation unit 20 and the evaluation unit 11 in the X direction.

As illustrated in FIG. 5, position A, position B, and position C are defined. Position A is a -X-direction position of the preparation unit 20. Position B is a position of the third solar cell element 1c in the evaluation unit 11. Position C is a +X-direction position of the evaluation unit 11.

Y-direction positions of the synchronous movement portions of the rotating belts 71 and 72 are as follows. As illustrated in FIG. 7, a Y-direction position of the synchronous movement portion of the second rotating belt 72 is constant. The synchronous movement portion of the first rotating belt 71 inclines in the +Y direction from position A to position B, and inclines in the -Y direction from position B to position C. Distances WA, WB, and WC in the Y direction between the synchronous movement portion of the first rotating belt 71 and the synchronous movement portion of the second rotating belt 72 are as follows. Among the distance WA at position A, the distance WB at position B, and the distance WC at position C, relationships WB > WA and WB > WC hold.

Z-direction positions of the synchronous movement portions of the rotating belts 71 and 72 are constant, but may be inclined as follows. The synchronous movement portions of the rotating belts 71 and 72 are inclined in the +Z direction from position A to position B, and are inclined in the -Z direction from position B to position C. A distance between the synchronous movement portions of the rotating belts 71 and 72 and the third solar cell element 1c is narrow at position B and is wide at positions A and C.

FIG. 8 is an enlarged view of portion VIII at position A of FIG. 7. FIG. 9 is a cross-sectional view along line IX-IX of FIG. 8.

The hook 75 is fixed to the rotating belts 71 and 72. A plurality of hooks 75 are disposed to be aligned in a circumferential direction of the rotating belts 71 and 72 at the same pitch as the through holes 5 of the third solar cell element 1c. In the synchronous movement portions of the rotating belts 71 and 72, the hook 75 is disposed in the +Z direction of the rotating belts 71 and 72. The hook 75 of the synchronous movement portion of the first rotating belt 71 extends in the +Z direction from the first rotating belt 71 and bends in the +Y direction. The hook 75 of the synchronous movement portion of the second rotating belt 72 extends in the +Z direction from the first rotating belt 71 and bends in the -Y direction.

An operation of the performance evaluation device 10 of the third embodiment will be described.

After the power generation performance is evaluated in the evaluation unit 11 illustrated in FIG. 5, the rotating member 60 moves in the +Z direction. The probe 62 of the evaluation unit 11 is separated from the connection pad 15p of the measurement unit 15. The probe 62 of the preparation unit 20 is separated from the connection pad 61p of the resistor 61. Before the third solar cell element 1c is transported, the connection between the third solar cell element 1c and the resistor 61 is released.

The transport device 18 and the rotating member 60 also extend in the -X direction of the preparation unit 20. An operator connects the cable 6 of the third solar cell element 1c at position A to the probe 62 of the rotating member 60.

As illustrated in FIGS. 8 and 9, the hook 75 of the synchronous movement portions of the rotating belts 71 and 72 enters the through hole 5 of the third solar cell element 1c at position A. The hook 75 enters the through hole 5 from the -Z direction of the third solar cell element 1c. Since an apex portion of the hook 75 in the +Z direction has a protruding shape, the hook 75 can easily enter the through hole 5. At position A, the hook 75 of the synchronous movement portions of the rotating belts 71 and 72 is at a center of the through hole 5 in the Y direction.

The transport device 18 illustrated in FIG. 5 transports the third solar cell element 1c in the +X direction. The third solar cell element 1c after evaluation exits the evaluation unit 11 to position C, and the third solar cell element 1c before evaluation enters the evaluation unit 11. The third solar cell element 1c, which has been at position A, enters the preparation unit 20. In synchronization with the transport device 18, the synchronous movement portion 64 of the rotating member 60 moves in the +X direction.

As illustrated in FIG. 7, the synchronous movement portion of the first rotating belt 71 is inclined in the +Y direction from position A to position B.

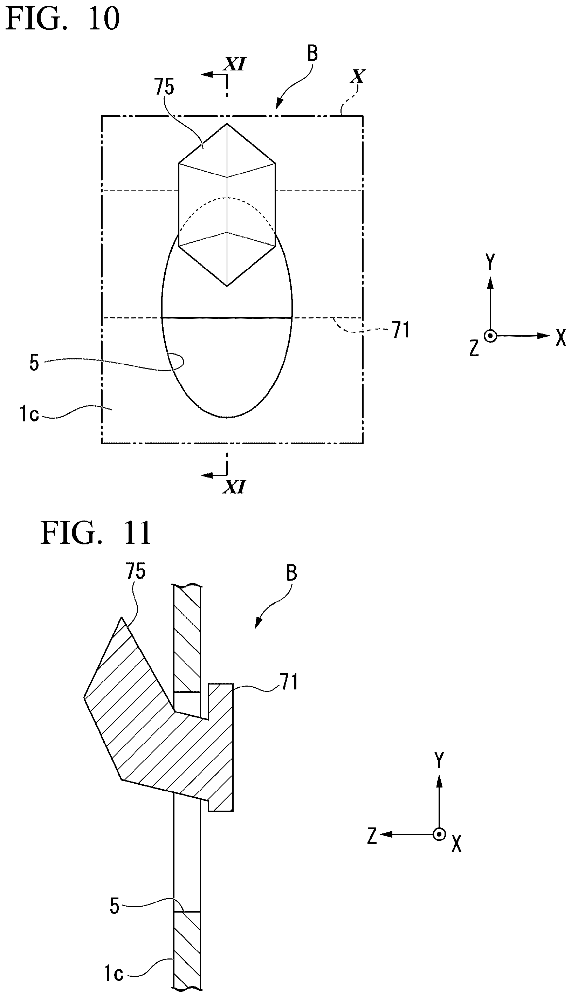

FIG. 10 is an enlarged view of portion X at position B of FIG. 7. FIG. 11 is a cross-sectional view along line XI-XI of FIG. 10. At position B, the hook 75 of the synchronous movement portions of the rotating belts 71 and 72 protrudes in the +Z direction of the through hole 5 of the third solar cell element 1c. At position B, the hook 75 of the synchronous movement portion of the first rotating belt 71 moves to an end part of the through hole 5 in the +Y direction. The hook 75 of the synchronous movement portions of the rotating belts 71 and 72 engages with the through hole 5. The third solar cell element 1c is pulled in the Y direction by the hook 75 of the synchronous movement portions of the rotating belts 71 and 72. In the evaluation unit 11 at position B illustrated in FIG. 7, the bending of the third solar cell element 1c is eliminated. In the evaluation unit 11, the transport device 18 can adsorb the third solar cell element 1c. In the evaluation unit 11, the third solar cell element 1c is sufficiently irradiated with light. In the preparation unit 20 between position A and position B, the third solar cell element 1c is pulled further in the Y direction as it is transported in the +X direction. Also in the preparation unit 20, the third solar cell element 1c is sufficiently irradiated with light.

As illustrated in FIG. 7, the synchronous movement portion of the first rotating belt 71 is inclined in the -Y direction from position B to position C.

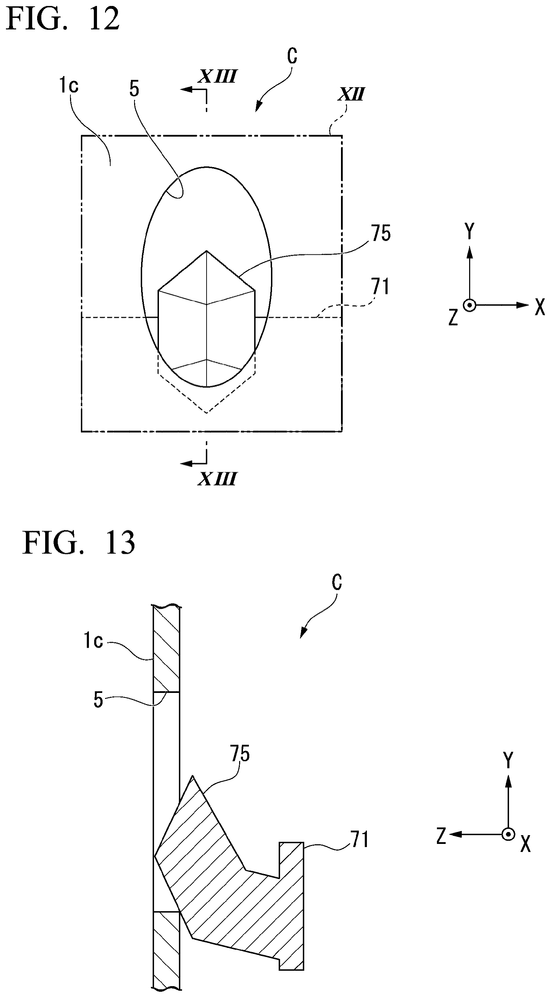

FIG. 12 is an enlarged view of portion XII at position C of FIG. 7. FIG. 13 is a cross-sectional view along line XIII-XIII of FIG. 12. At position C, the hook 75 of the synchronous movement portion of the first rotating belt 71 moves to an end part of the through hole 5 in the -Y direction. At position C, the hook 75 of the synchronous movement portions of the rotating belts 71 and 72 exits in the -Z direction from the through hole 5 of the third solar cell element 1c. Since an end part of the hook 75 in the -Y direction is inclined in the -Y direction toward the -Z direction, the hook 75 can easily exit the through hole 5. The engagement between the hook 75 of the synchronous movement portions of the rotating belts 71 and 72 and the through hole 5 is released.

The operator releases the connection between the cable 6 of the third solar cell element 1c at position C and the probe 62 of the rotating member 60. The third solar cell element 1c after evaluation is taken out from the performance evaluation device 10.

The rotating member 60 moves in the -Z direction. The probe 62 of the evaluation unit **11** comes into contact with the connection pad 15p of the measurement unit 15. The probe 62 of the preparation unit 20 comes into contact with the connection pad 61p of the resistor 61. After the third solar cell element 1c is transported, the third solar cell element 1c and the resistor 61 are connected to each other. The third solar cell element 1c, that is adjacent to the third solar cell element 1c in the -X direction from which the connection with the resistor 61 has been released before the third solar cell element 1c is transported, and the resistor 61 are connected after the third solar cell element 1c is transported. The resistors 61 are sequentially connected to the plurality of third solar cell elements 1c.

As described above in detail, the performance evaluation device 10 for solar cell elements in the third embodiment further includes the endless rotating member 60. The rotating member 60 includes the synchronous movement portion 64 that is movable in synchronization with the transport device 18. The rotating member 60 holds the probe 62 capable of connecting the cable 6 extending from the third solar cell element 1c and the resistor 61. The rotating member 60 is movable in the Z direction that intersects the surface of the connection pad 61p of the resistor 61.

Due to the cooperation between the rotating member 60 and the transport device 18, the resistors 61 are sequentially connected to the plurality of third solar cell elements 1c. The number of resistors 61 matches the number of third solar cell elements 1c included in the preparation unit 20. Since only a small number of resistors 61 are required, costs of the performance evaluation device 10 are reduced.

The probe 62 is capable of connecting the cable 6 extending from the third solar cell element 1c and the measurement unit 15 of the evaluation unit 11.

With the cable 6 extending from the third solar cell element 1c remaining connected to the probe 62, the third solar cell element 1c can be sequentially connected to the resistor 61 of the preparation unit 20 and the measurement unit 15 of the evaluation unit 11. An evaluation time of the performance evaluation device 10 is reduced.

The performance evaluation device 10 further includes the tension mechanism 70. The tension mechanism 70 pulls the third solar cell element 1c in the Y direction that intersects the -Z direction which is a light irradiation direction of the first light source 12 and the second light source 22.

The bending of the third solar cell element 1c is eliminated. The transport device 18 can adsorb the third solar cell element 1c. The third solar cell element 1c is sufficiently irradiated with light.

The solar cell element 1 is not limited to the first solar cell element 1a, the second solar cell element 1b, and the third solar cell element 1c. If the resistor can be connected to the solar cell element 1 in the preparation unit 20, the performance evaluation device 10 can handle all types of the solar cell elements 1.

According to at least one of the embodiments described above, the preparation unit 20, which irradiates the solar cell element 1 containing a perovskite semiconductor with light before evaluating the power generation performance of the solar cell element 1, is provided. Thereby, an evaluation time of the performance evaluation device 10 can be reduced.

Further, in each embodiment, the solar cell element has been described as having a two-terminal configuration, but it may alternatively have a three-terminal type with a GND terminal interposed or may have a four-terminal type with two pairs of positive and negative terminals.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

### REFERENCE SIGNS LIST

1 Solar cell element
2 Terminal
3 Cable
10 Performance evaluation device
11 Evaluation unit
12 First light source
15p Connection pad
18 Transport device
20 Preparation unit
22 Second light source
30 Support member
31, 41, 51, 61 Resistor
32, 42, 52, 62 Probe
50, 60 Rotating member
61p Connection pad
54, 64 Synchronous movement portion
70 Tension mechanism

## Claims

1. A performance evaluation device for solar cell elements comprising:
an evaluation unit including a first light source which irradiates each of solar cell elements containing a perovskite semiconductor with light, and evaluating a power generation performance of the solar cell element; and
a preparation unit including a second light source which irradiates the solar cell elements with light before the solar cell elements are each transported to the evaluation unit, and preparing for evaluation of power generation performances of the solar cell elements.

2. The performance evaluation device for solar cell elements according to claim 1, wherein the preparation unit includes a resistor which is able to form a closed circuit by being connected to the solar cell element.

3. The performance evaluation device for solar cell elements according to claim 2, further comprising a transport device extending in a first direction from the preparation unit toward the evaluation unit, supporting the solar cell elements aligned in a row, and sequentially transporting the solar cell elements to the evaluation unit.

4. The performance evaluation device for solar cell elements according to claim 3, wherein
the connection between the solar cell element and the resistor is released before the solar cell element is transported, and
the solar cell element, which is adjacent to the solar cell element on an upstream side in the first direction from which the connection with the resistor has been released, and the resistor are connected after the solar cell element is transported.

5. The performance evaluation device for solar cell elements according to claim 4, wherein
the preparation unit includes the resistor and a probe which enables the resistor to be connected to the solar cell element; and
the probe is movable in a direction intersecting a surface of a terminal of the solar cell element.

6. The performance evaluation device for solar cell elements according to claim 3, wherein the resistor moves in synchronization with the solar cell element while being connected to the solar cell element.

7. The performance evaluation device for solar cell elements according to claim 6, further comprising an endless rotating member having a portion which is movable in synchronization with the transport device.

8. The performance evaluation device for solar cell elements according to claim 7, wherein
the rotating member holds the resistor and a probe which enables the resistor to be connected to the solar cell element; and
the rotating member is movable in a direction intersecting a surface of a terminal of the solar cell element.

9. The performance evaluation device for solar cell elements according to claim 4, further comprising an endless rotating member having a portion which is movable in synchronization with the transport device, wherein
the rotating member holds a probe which is connectable between a cable extending from the solar cell element and the resistor, and
the rotating member is movable in a direction intersecting a surface of a connection pad of the resistor.

10. The performance evaluation device for solar cell elements according to claim 9, wherein the probe is connectable between a cable extending from the solar cell element and a connection pad of the evaluation unit.

11. The performance evaluation device for solar cell elements according to claim 9, further comprising a tension mechanism which pulls the solar cell element in a direction intersecting light irradiation directions of the first light source and the second light source.

12. The performance evaluation device for solar cell elements according to any one of claims 1 to 11, wherein the second light source is an LED.

13. A performance evaluation method for solar cell elements comprising:
a preparation step of irradiating solar cell elements containing a perovskite semiconductor with light before power generation performances of the solar cell elements are evaluated; and
an evaluation step of evaluating the power generation performance of each of the solar cell elements.
